# EUROPEAN PATENT APPLICATION

(11) **EP 4 580 364 A1**
(43) Date of publication of application: **02.07.2025**
(21) Application number: 24222763.5
(22) Date of filing: 23.12.2024
(51) Int. Cl.: H10K 59/121, H10K 59/131, H10K 59/35

(54) **DISPLAY DEVICE**

(30) Priority: 27.12.2023 JP 2023220902
(71) Applicant: Japan Display Inc., Tokyo 105-0003 (JP)
(72) Inventor: FUJIMOTO, Takamitsu, Tokyo, 105-0003 (JP); TAKAHASHI, Hideyuki, Tokyo, 105-0003 (JP); HARADA, Kenji, Tokyo, 105-0003 (JP); SUZUKI, Takayuki, Tokyo, 105-0003 (JP)
(74) Representative: MERH-IP Matias Erny Reichl Hoffmann Patentanwälte PartG mbB

(57) **Abstract**

According to one embodiment, a display device includes a plurality of first subpixels (SPa) arranged in a display area (DA), a plurality of second subpixels (SPb) arranged in the display area (DA), a first signal line (SLa) which supplies a video signal to each of the first subpixels (SPa), a second signal line (SLb) which supplies a video signal to each of the second subpixels (SPb), a first correction capacitive portion (7a) which is provided in a surrounding area (SA) located around the display area (DA) and is connected to the first signal line (SLa), a second correction capacitive portion (7b) provided in the surrounding area (SA) and connected to the second signal line (SLb), and a connection line (CL) which connects the first correction capacitive portion (7a) and the second correction capacitive portion (7b) to each other and has a meandering shape.

## Description

### FIELD

Embodiments described herein relate generally to a display device.

### BACKGROUND

Recently, display devices to which an organic light emitting diode (OLED) is applied as a display element have been put into practical use. In this type of display devices, a technique for further improving the display quality is required.

### BRIEF DESCRIPTION OF THE DRAWINGS

FIG. 1 is a diagram showing a configuration example of a display device according to an embodiment.
FIG. 2 is a circuit diagram showing an example of a configuration which can be applied to a pixel circuit provided in a subpixel.
FIG. 3 is a schematic plan view showing an example of the layout form of three pixel circuits provided for one pixel.
FIG. 4 is a schematic plan view showing an example of the layout of the display elements of three subpixels.
FIG. 5 is the schematic cross-sectional view of the display device along the V-V line of FIG. 4.
FIG. 6 is a schematic cross-sectional view showing an example of a layer configuration which could be applied to a circuit layer.
FIG. 7 is a diagram showing a configuration example of each transistor included in the circuit layer.
FIG. 8 is a diagram showing another configuration example of each transistor included in the circuit layer.
FIG. 9 is a schematic plan view showing a circuit related to power source voltage (VDDEL).
FIG. 10 is a plan view showing a schematic configuration of a connection portion.
FIG. 11 is a diagram for explaining the function of correction capacitance.
FIG. 12 is a diagram showing an example of the layout form of correction capacitive portions.
FIG. 13 is a diagram showing another example of the layout form of the correction capacitive portions.
FIG. 14 is a schematic plan view of a plurality of correction capacitive portions according to a first practical example.
FIG. 15 is a schematic plan view in which one of the correction capacitive portions of FIG. 14 is enlarged.
FIG. 16 is the schematic cross-sectional view of the correction capacitive portion along the XVI-XVI line of FIG. 15.
FIG. 17 is a schematic plan view of a plurality of correction capacitive portions according to a second practical example.
FIG. 18 is a schematic plan view in which one of the correction capacitive portions of FIG. 17 is enlarged.
FIG. 19 is the schematic cross-sectional view of the correction capacitive portion along the IXX-IXX line of FIG. 18.
FIG. 20 is a schematic cross-sectional view of a correction capacitive portion according to a third practical example.

### DETAILED DESCRIPTION

In general, according to one embodiment, a display device comprises a plurality of first subpixels arranged in a display area, a plurality of second subpixels arranged in the display area, a first signal line which supplies a video signal to each of the first subpixels, a second signal line which supplies a video signal to each of the second subpixels, a first correction capacitive portion which is provided in a surrounding area located around the display area and is connected to the first signal line, a second correction capacitive portion provided in the surrounding area and connected to the second signal line, and a connection line which connects the first correction capacitive portion and the second correction capacitive portion to each other and has a meandering shape.

According to another aspect of the embodiment, a display device comprises a plurality of subpixels provided in a display area, a signal line which supplies a video signal to each of the subpixels, a power line which applies power source voltage to each of the subpixels, and a correction capacitive portion which is provided in a surrounding area located around the display area and is connected to the signal line. Each of the subpixels includes a pixel circuit connected to the signal line and the power line, a lower electrode connected to the pixel circuit, an upper electrode which faces the lower electrode, and an organic layer which is located between the lower electrode and the upper electrode and emits light based on application of voltage. Further, the correction capacitive portion includes a first capacitive electrode formed of a same material as the signal line in a same layer as the signal line and connected to the signal line, and a second capacitive electrode formed of a same material as the power line in a same layer as the power line and forming correction capacitance between the first capacitive electrode and the second capacitive electrode.

According to yet another aspect of the embodiment, a display device comprises a plurality of subpixels provided in a display area, a signal line which supplies a video signal to each of the subpixels, and a correction capacitive portion which is provided in a surrounding area located around the display area and is connected to the signal line. Each of the subpixels includes a pixel circuit which comprises a transistor including a gate electrode and a semiconductor and is connected to the signal line, a lower electrode connected to the pixel circuit, an upper electrode which faces the lower electrode, and an organic layer which is located between the lower electrode and the upper electrode and emits light based on application of voltage. The correction capacitive portion includes a first capacitive electrode formed of a same material as the gate electrode in a same layer as the gate electrode and connected to the signal line, and a second capacitive electrode formed of a same material as the semiconductor in a same layer as the semiconductor and forming correction capacitance between the first capacitive electrode and the second capacitive electrode.

These configurations can provide a display device in which the display quality can be further improved.

Embodiments will be described with reference to the accompanying drawings.

The disclosure is merely an example, and proper changes in keeping with the spirit of the invention, which are easily conceivable by a person of ordinary skill in the art, come within the scope of the invention as a matter of course. In addition, in some cases, in order to make the description clearer, the widths, thicknesses, shapes, etc., of the respective parts are illustrated schematically in the drawings, rather than as an accurate representation of what is implemented. However, such schematic illustration is merely exemplary, and in no way restricts the interpretation of the invention. In addition, in the specification and drawings, structural elements which function in the same or a similar manner to those described in connection with preceding drawings are denoted by like reference numbers, detailed description thereof being omitted unless necessary.

In the drawings, in order to facilitate understanding, an X-axis, a Y-axis and a Z-axis orthogonal to each other are shown depending on the need. A direction parallel to the X-axis is referred to as an X-direction. A direction parallel to the Y-axis is referred to as a Y-direction. A direction parallel to the Z-axis is referred to as a Z-direction. The Z-direction is the normal direction of a plane including the X-direction and the Y-direction. When various elements are viewed parallel to the Z-direction, the appearance is defined as a plan view.

The display device of each embodiment is an organic electroluminescent display device comprising an organic light emitting diode (OLED) as a display element, and could be mounted on various types of electronic devices such as a television, a personal computer, a vehicle-mounted device, a tablet, a smartphone, a mobile phone and a wearable terminal.

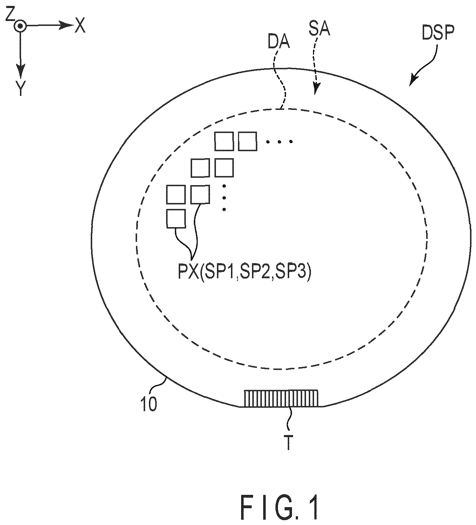

FIG. 1 is a diagram showing a configuration example of a display device DSP according to an embodiment. The display device DSP comprises an insulating substrate 10. The substrate 10 has a display area DA which displays an image, and a surrounding area SA located around the display area DA. The substrate 10 may be glass or a resinous film having flexibility.

In the embodiment, the substrate 10 and the display area DA are oval as seen in plan view. It should be noted that the shape of each of the substrate 10 and the display area DA in plan view is not limited to an oval and may be another shape such as a rectangle, a square or a precise circle.

The display area DA comprises a plurality of pixels PX arrayed in matrix in an X-direction and a Y-direction. Each pixel PX includes a plurality of subpixels SP which display different colors. This embodiment assumes a case where each pixel PX includes a red subpixel SP1, a green subpixel SP2 and a blue subpixel SP3. However, each pixel PX may include a subpixel SP which exhibits another color such as white in addition to subpixels SP1, SP2 and SP3 or instead of one of subpixels SP1, SP2 and SP3.

The display device DSP further comprises a terminal portion T provided in the surrounding area SA. For example, a flexible printed circuit which applies voltage and signals for driving the display device DSP is connected to the terminal portion T.

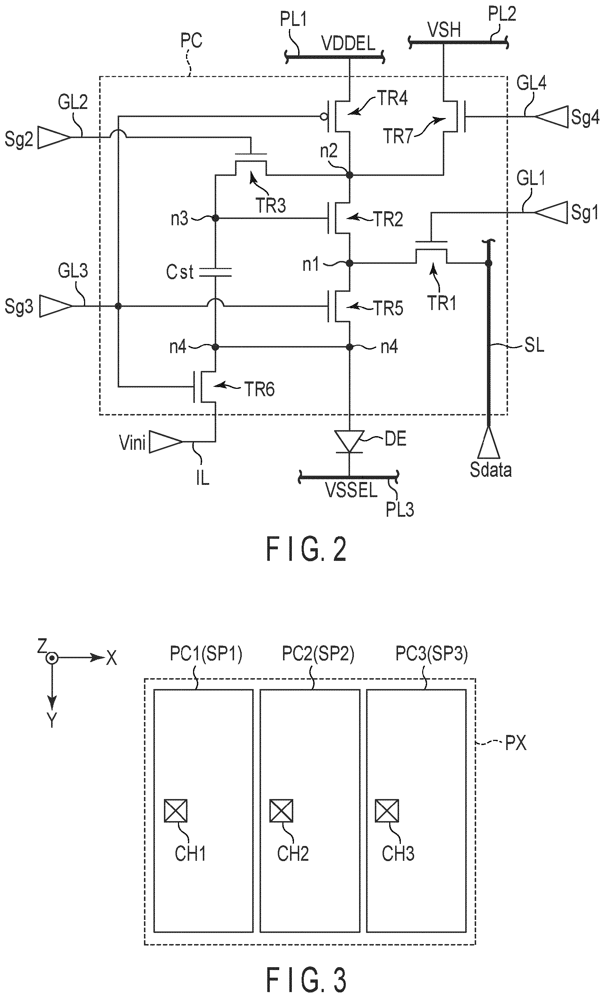

FIG. 2 is a circuit diagram showing an example of a configuration which can be applied to a pixel circuit PC provided in each subpixel SP (SP1, SP2 or SP3). The pixel circuit PC shown in the figure includes seven transistors TR1 to TR7 and a storage capacitor Cst.

In the following explanation, one of the source and drain electrodes of each of the transistors TR1 to TR7 is referred to as a first electrode, and the other one is referred to as a second electrode. Similarly, one electrode of the storage capacitor Cst is referred to as a first electrode, and the other electrode is referred to as a second electrode.

The first electrode of the transistor TR1 is connected to a node n1. The second electrode of the transistor TR1 is connected to a signal line SL which supplies video signals Sdata. Video signals Sdata are signals which are written to pixels for image display.

The transistor TR2 corresponds to a drive transistor which supplies current to a light emitting element DE included in the subpixel SP. The first electrode of the transistor TR2 is connected to the node n1. The second electrode of the transistor TR2 is connected to a node n2.

The first electrode of the transistor TR3 is connected to a node n3. The second electrode of the transistor TR3 is connected to the node n2.

The first electrode of the transistor TR4 is connected to the node n2. The second electrode of the transistor TR4 is connected to a power line PL1 which applies power source voltage VDDEL.

The first electrode of the transistor TR5 is connected to a node n4. The second electrode of the transistor TR5 is connected to the node n1.

The first electrode of the transistor TR6 is connected to the node n4. The second electrode of the transistor TR6 is connected to an initialization line IL which applies initialization voltage Vini.

The first electrode of the transistor TR7 is connected to the node n2. The second electrode of the transistor TR7 is connected to a power line PL2 which applies power source voltage VSH.

The first electrode of the storage capacitor Cst is connected to the node n3. The second electrode of the storage capacitor Cst is connected to the node n4.

The gate electrode of the transistor TR1 is connected to a scanning line GL1 which supplies scanning signals Sg1. The gate electrode of the transistor TR3 is connected to a scanning line GL2 which supplies scanning signals Sg2. The gate electrodes of the transistors TR4, TR5 and TR6 are connected to a scanning line GL3 which supplies scanning signals Sg3. The gate electrode of the transistor TR7 is connected to a scanning line GL4 which supplies scanning signals Sg4.

The anode of the display element DE is connected to the node n4. The cathode of the display element DE is connected to a power line PL3 which applies power source voltage VSSEL. The power source voltage VDDEL described above corresponds to anode voltage which is applied to the display element DE. Power source voltage VSSEL corresponds to cathode voltage which is applied to the display element DE.

It should be noted that the configuration of the pixel circuit PC is not limited to the example shown in FIG. 2. For example, the pixel circuit PC may comprise six or less or eight or more transistors. Further, the pixel circuit PC may comprise a plurality of storage capacitors Cst.

FIG. 3 is a schematic plan view showing an example of the layout form of the pixel circuits PC provided for one pixel PX. In the example of FIG. 3, the pixel circuits PC (PC1, PC2 and PC3) of subpixels SP1, SP2 and SP3 are arranged in the X-direction.

The pixel circuits PC1, PC2 and PC3 are connected to the display elements DE of subpixels SP1, SP2 and SP3 via contact holes CH1, CH2 and CH3 provided in an organic insulating layer 12 as described later, respectively. In the example of FIG. 3, the contact holes CH1, CH2 and CH3 are arranged in the X-direction.

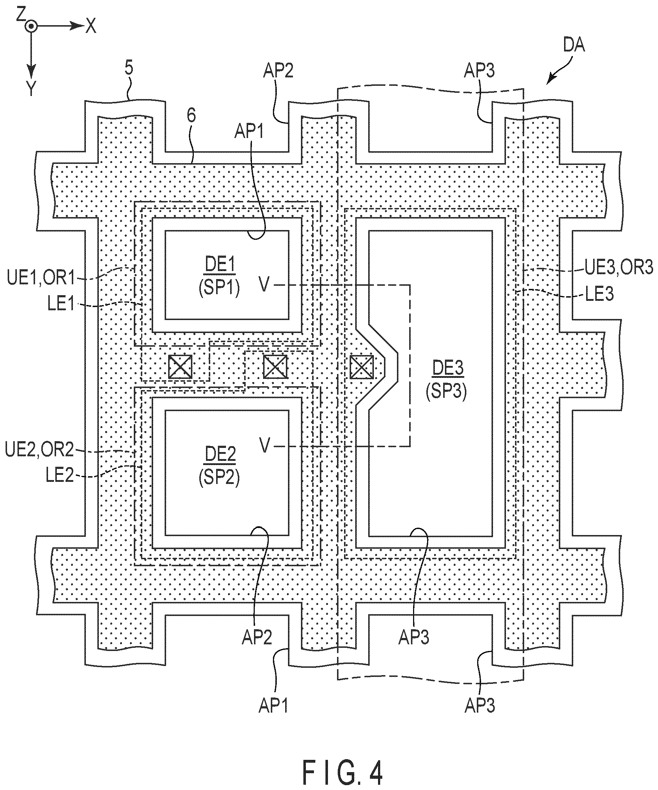

FIG. 4 is a schematic plan view showing an example of the layout of the display elements DE (DE1, DE2 and DE3) of subpixels SP1, SP2 and SP3. In the example of FIG. 4, each of the display elements DE1 and DE2 is adjacent to the display element DE3 in the X-direction. Further, the display elements DE1 and DE2 are arranged in the Y-direction.

When the display elements DE1, DE2 and DE3 are provided in line with this layout, a column in which the display elements DE1 and DE2 are alternately provided in the Y-direction and a column in which a plurality of display elements DE3 are repeatedly provided in the Y-direction are formed in the display area DA. These columns are alternately arranged in the X-direction. It should be noted that the layout of the display elements DE1, DE2 and DE3 is not limited to the example of FIG. 4.

A rib 5 is provided in the display area DA. The rib 5 has a pixel aperture AP1 which surrounds the display element DE1, a pixel aperture AP2 which surrounds the display element DE2 and a pixel aperture AP3 which surrounds the display element DE3.

In the example of FIG. 4, the pixel aperture AP2 is larger than the pixel aperture AP1. The pixel aperture AP3 is larger than the pixel aperture AP2. Thus, among subpixels SP1, SP2 and SP3, the aperture ratio of subpixel SP3 is the greatest, and the aperture ratio of subpixel SP1 is the least. However, the relationship of the aperture ratios of subpixels SP1, SP2 and SP3 is not limited to this example.

The display element DE1 comprises a lower electrode LE1, an upper electrode UE1 and an organic layer OR1 overlapping the pixel aperture AP1. The display element DE2 comprises a lower electrode LE2, an upper electrode UE2 and an organic layer OR2 overlapping the pixel aperture AP2. The display element DE3 comprises a lower electrode LE3, an upper electrode UE3 and an organic layer OR3 overlapping the pixel aperture AP3.

A partition 6 having a grating shape is provided on the rib 5. The partition 6 overlaps the rib 5 as a whole and has a planar shape similar to that of the rib 5. In other words, the partition 6 has apertures which surround the display elements DE1, DE2 and DE3. The partition 6 functions as lines which apply cathode voltage to the upper electrodes UE1, UE2 and UE3. Each of the contact holes CH1, CH2 and CH3 described above overlaps the rib 5 and the partition 6.

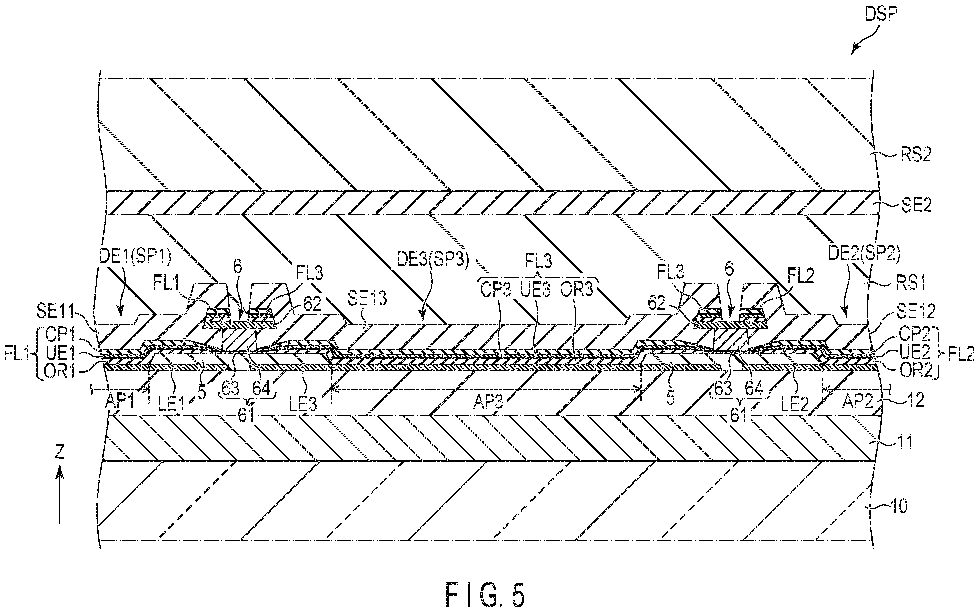

FIG. 5 is the schematic cross-sectional view of the display device DSP along the V-V line of FIG. 4. A circuit layer 11 is provided on the substrate 10 described above. The circuit layer 11 includes various circuits and lines such as the pixel circuits PC (PC1, PC2 and CP3), signal lines SL, initialization lines IL, power lines PL1, PL2 and PL3 and scanning lines GL1, GL2, GL3 and GL4 shown in FIG. 2. The circuit layer 11 is covered with the organic insulating layer 12. The organic insulating layer 12 functions as a planarization film which planarizes the irregularities formed by the circuit layer 11.

The lower electrodes LE1, LE2 and LE3 are provided on the organic insulating layer 12. The rib 5 is provided on the organic insulating layer 12 and the lower electrodes LE1, LE2 and LE3. The end portions of the lower electrodes LE1, LE2 and LE3 are covered with the rib 5. The lower electrodes LE1, LE2 and LE3 are connected to the pixel circuits PC1, PC2 and PC3 of the circuit layer 11 through the contact holes CH1, CH2 and CH3 (see FIG. 3 and FIG. 4) provided in the organic insulating layer 12, respectively.

The partition 6 includes a conductive lower portion 61 provided on the rib 5 and an upper portion 62 provided on the lower portion 61. The upper portion 62 has a width greater than that of the lower portion 61. By this configuration, the both end portions of the upper portion 62 protrude relative to the side surfaces of the lower portion 61. This shape of the partition 6 is called an overhang shape.

In the example of FIG. 5, the lower portion 61 has a bottom layer 63 provided on the rib 5, and a stem layer 64 provided on the bottom layer 63. For example, the bottom layer 63 is formed so as to be thinner than the stem layer 64. In the example of FIG. 5, the both end portions of the bottom layer 63 protrude from the side surfaces of the stem layer 64.

The organic layer OR1 covers the lower electrode LE1 through the pixel aperture AP1. The upper electrode UE1 covers the organic layer OR1 and faces the lower electrode LE1. The organic layer OR2 covers the lower electrode LE2 through the pixel aperture AP2. The upper electrode UE2 covers the organic layer OR2 and faces the lower electrode LE2. The organic layer OR3 covers the lower electrode LE3 through the pixel aperture AP3. The upper electrode UE3 covers the organic layer OR3 and faces the lower electrode LE3. The upper electrodes UE1, UE2 and UE3 are in contact with the side surfaces of the lower portions 61 of the partition 6.

The display element DE1 includes a cap layer CP1 provided on the upper electrode UE1. The display element DE2 includes a cap layer CP2 provided on the upper electrode UE2. The display element DE3 includes a cap layer CP3 provided on the upper electrode UE3. The cap layers CP1, CP2 and CP3 function as optical adjustment layers which improve the extraction efficiency of the light emitted from the organic layers OR1, OR2 and OR3, respectively.

In the following explanation, a multilayer body including the organic layer OR1, the upper electrode UE1 and the cap layer CP1 is called a stacked film FL1. A multilayer body including the organic layer OR2, the upper electrode UE2 and the cap layer CP2 is called a stacked film FL2. A multilayer body including the organic layer OR3, the upper electrode UE3 and the cap layer CP3 is called a stacked film FL3.

The stacked film FL1 is partly located on the upper portion 62. This portion is spaced apart from, of the stacked film FL1, the portion located around the partition 6 (in other words, the portion which constitutes the display element DE1). Similarly, the stacked film FL2 is partly located on the upper portion 62. This portion is spaced apart from, of the stacked film FL2, the portion located around the partition 6 (in other words, the portion which constitutes the display element DE2). Further, the stacked film FL3 is partly located on the upper portion 62. This portion is spaced apart from, of the stacked film FL3, the portion located around the partition 6 (in other words, the portion which constitutes the display element DE3).

Sealing layers SE11, SE12 and SE13 are provided in subpixels SP1, SP2 and SP3, respectively. The sealing layer SE11 continuously covers the cap layer CP1 and the partition 6 around subpixel SP1. The sealing layer SE12 continuously covers the cap layer CP2 and the partition 6 around subpixel SP2. The sealing layer SE13 continuously covers the cap layer CP3 and the partition 6 around subpixel SP3.

In the example of FIG. 5, the stacked film FL1 and sealing layer SE11 located on the partition 6 between the display elements DE1 and DE3 are spaced apart from the stacked film FL3 and sealing layer SE13 located on this partition 6. The stacked film FL2 and sealing layer SE12 located on the partition 6 between the display elements DE2 and DE3 are spaced apart from the stacked film FL3 and sealing layer SE13 located on this partition 6.

The sealing layers SE11, SE12 and SE13 are covered with a resin layer RS1. The resin layer RS1 is covered with a sealing layer SE2. The sealing layer SE2 is covered with a resin layer RS2. The resin layers RS1 and RS2 and the sealing layer SE2 are continuously provided in at least the entire display area DA and partly extend to the surrounding area SA.

A cover member such as a polarizer, a touch panel, a protective film or a cover glass may be further provided above the resin layer RS2. This cover member may be attached to the resin layer RS2 via, for example, an adhesive layer such as an optical clear adhesive (OCA).

The organic insulating layer 12 is formed of an organic insulating material such as polyimide. Each of the rib 5 and the sealing layers SE11, SE12, SE13 and SE2 is formed of an inorganic insulating material such as silicon nitride (SiNx), silicon oxide (SiOx) or silicon oxynitride (SiON). For example, the rib 5 is formed of silicon oxynitride, and each of the sealing layers SE11, SE12, SE13 and SE2 is formed of silicon nitride. Each of the resin layers RS1 and RS2 is formed of, for example, a resinous material (organic insulating material) such as epoxy resin or acrylic resin.

Each of the lower electrodes LE1, LE2 and LE3 has a reflective layer formed of, for example, silver, and a pair of conductive oxide layers covering the upper and lower surfaces of the reflective layer. Each of the conductive oxide layers can be formed of, for example, a transparent conductive oxide such as indium tin oxide (ITO), indium zinc oxide (IZO) or indium gallium zinc oxide (IGZO).

Each of the upper electrodes UE1, UE2 and UE3 is formed of, for example, a metal material such as an alloy of magnesium and silver (MgAg). In this embodiment, the lower electrodes LE1, LE2 and LE3 correspond to anodes, and the upper electrodes UE1, UE2 and UE3 correspond to cathodes.

Each of the organic layers OR1, OR2 and OR3 consists of a plurality of thin films including a light emitting layer. For example, each of the organic layers OR1, OR2 and OR3 comprises a structure in which a hole injection layer, a hole transport layer, an electron blocking layer, a light emitting layer, a hole blocking layer, an electron transport layer and an electron injection layer are stacked in order in a Z-direction. It should be noted that each of the organic layers OR1, OR2 and OR3 may comprise another structure such as a tandem structure including a plurality of light emitting layers.

Each of the cap layers CP1, CP2 and CP3 comprises, for example, a multilayer structure in which a plurality of transparent layers are stacked. These transparent layers could include a layer formed of an inorganic material and a layer formed of an organic material. The transparent layers have refractive indices different from each other. For example, the refractive indices of these transparent layers are different from the refractive indices of the upper electrodes UE1, UE2 and UE3 and the refractive indices of the sealing layers SE11, SE12 and SE13. It should be noted that at least one of the cap layers CP1, CP2 and CP3 may be omitted.

Each of the bottom layer 63 and stem layer 64 of the partition 6 is formed of a metal material. For the metal material of the bottom layer 63, for example, molybdenum, titanium, titanium nitride (TiN), a molybdenum-tungsten alloy (MoW) or a molybdenum-niobium alloy (MoNb) can be used. For the metal material of the stem layer 64, for example, aluminum, an aluminum-neodymium alloy (AlNd), an aluminum-yttrium alloy (AlY) or an aluminum-silicon alloy (AlSi) can be used. It should be noted that the stem layer 64 may be formed of an insulating material.

For example, the upper portion 62 of the partition 6 comprises a multilayer structure consisting of a lower layer formed of a metal material and an upper layer formed of conductive oxide. For the metal material forming the lower layer, for example, titanium, titanium nitride, molybdenum, tungsten, a molybdenum-tungsten alloy or a molybdenum-niobium alloy may be used. For the conductive oxide forming the upper layer, for example, ITO or IZO may be used. It should be noted that the upper portion 62 may comprise a single-layer structure of a metal material. The upper portion 62 may further include a layer formed of an insulating material.

Cathode voltage is applied to the partition 6. This cathode voltage is applied to each of the upper electrodes UE1, UE2 and UE3 which are in contact with the side surfaces of the lower portions 61. Voltage is applied to the lower electrodes LE1, LE2 and LE3 through the pixel circuits PC (PC1, PC2 and PC3) provided in subpixels SP1, SP2 and SP3, respectively, based on the video signals Sdata of the signal lines SL.

The organic layers OR1, OR2 and OR3 emit light based on the application of voltage. Specifically, when a potential difference is formed between the lower electrode LE1 and the upper electrode UE1, the light emitting layer of the organic layer OR1 emits light in a red wavelength range. When a potential difference is formed between the lower electrode LE2 and the upper electrode UE2, the light emitting layer of the organic layer OR2 emits light in a green wavelength range. When a potential difference is formed between the lower electrode LE3 and the upper electrode UE3, the light emitting layer of the organic layer OR3 emits light in a blue wavelength range.

As another example, the light emitting layers of the organic layers OR1, OR2 and OR3 may emit light exhibiting the same color (for example, white). In this case, the display device DSP may comprise color filters which convert the light emitted from the light emitting layers into light exhibiting colors corresponding to subpixels SP1, SP2 and SP3. The display device DSP may comprise a layer including quantum dots which generate light exhibiting colors corresponding to subpixels SP1, SP2 and SP3 by the excitation caused by the light emitted from the light emitting layers.

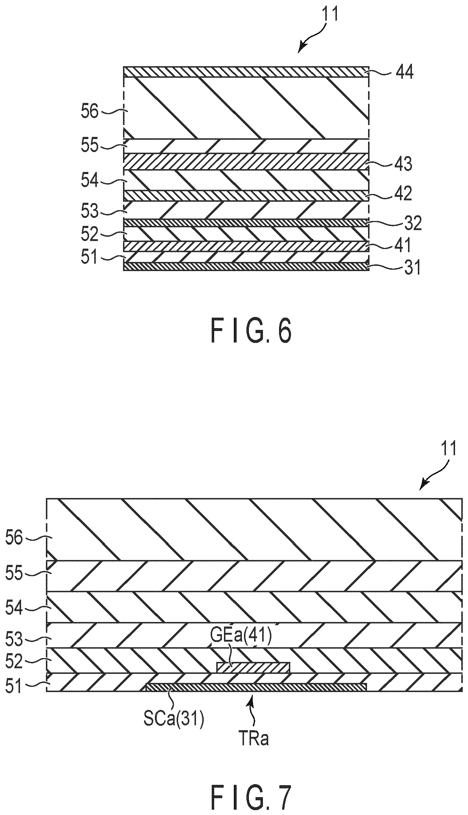

FIG. 6 is a schematic cross-sectional view showing an example of a layer configuration which could be applied to the circuit layer 11. In the example of this figure, the circuit layer 11 comprises semiconductor layers 31 and 32, metal layers 41, 42, 43 and 44, inorganic insulating layers 51, 52, 53, 54 and 55 and an organic insulating layer 56.

For example, the semiconductor layer 31 corresponds to the undermost layer of the circuit layer 11. It should be noted that an insulating layer may be provided under the semiconductor layer 31. The inorganic insulating layer 51 covers the semiconductor layer 31. The metal layer 41 is provided on the inorganic insulating layer 51. The inorganic insulating layer 52 covers the metal layer 41. The semiconductor layer 32 is provided on the inorganic insulating layer 52. The inorganic insulating layer 53 covers the semiconductor layer 32. The metal layer 42 is provided on the inorganic insulating layer 53. The inorganic insulating layer 54 covers the metal layer 42. The metal layer 43 is provided on the inorganic insulating layer 54. The inorganic insulating layer 55 covers the metal layer 43. The organic insulating layer 56 covers the inorganic insulating layer 55. The metal layer 44 is provided on the organic insulating layer 56 and is covered with the organic insulating layer 12 shown in FIG. 5.

For example, the semiconductor layer 31 is formed of low-temperature polysilicon formed at a low temperature. The semiconductor layer 32 is formed of an oxide semiconductor. A single-layer structure of a metal material or a multilayer structure using a plurality of metal materials can be applied to each of the metal layers 41 to 44. For example, each of the metal layers 41 and 42 is formed of a molybdenum-tungsten alloy (MoW), and each of the metal layers 43 and 44 is formed of a multilayer structure (TAT) in which an aluminum layer is interposed between a pair of tungsten layers.

Each of the inorganic insulating layers 51 to 55 is formed of, for example, an inorganic insulating material such as silicon nitride, silicon oxide or silicon oxynitride. The organic insulating layer 56 is formed of an organic insulating material such as polyimide so as to be thicker than the inorganic insulating layers 51 to 55.

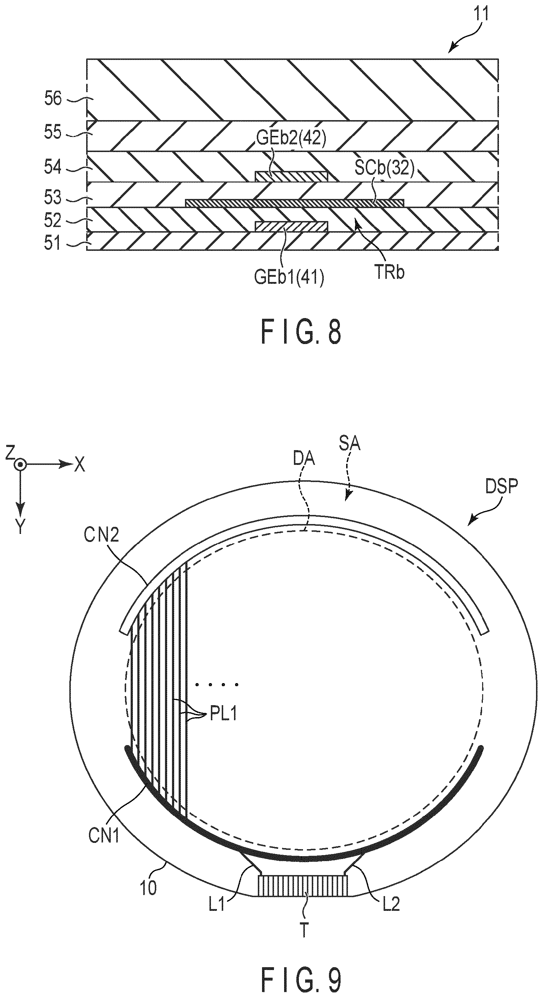

Each of FIG. 7 and FIG. 8 is a diagram showing a configuration example of the transistors (TFT) included in the circuit layer 11. The transistor TRa shown in FIG. 7 includes a semiconductor SCa, and a gate electrode GEa which faces this semiconductor SCa. The semiconductor SCa is formed by the semiconductor layer 31. The gate electrode GEa is formed by the metal layer 41.

The transistor TRb shown in FIG. 8 includes a semiconductor SCb, and gate electrodes GEb1 and GEb2 facing this semiconductor SCb. The semiconductor SCb is formed by the semiconductor layer 32. The gate electrode GEb1 is formed by the metal layer 41. The gate electrode GEb2 is formed by the metal layer 42.

The structure of one of these transistors TRa and TRb can be applied to each of the transistors TR1 to TR7 shown in FIG. 2. The source and drain electrodes (first and second electrodes) of the transistors TR1 to TR7 can be formed by at least one of the metal layers 41 to 44.

The signal line SL, initialization line IL, power lines PL1 to PL3 and scanning lines GL1 to GL4 shown in FIG. 2 are formed by one of the metal layers 41 to 44. For example, the signal line SL, the power line PL1 and the initialization line IL are formed by the metal layer 43. The power lines PL2 and PL3 are formed by the metal layer 44. The scanning lines GL1 to GL4 are formed by at least one of the metal layers 41 and 42.

FIG. 9 is a schematic plan view showing a circuit related to the power source voltage VDDEL described above. As shown in FIG. 2, power source voltage VDDEL is applied to the pixel circuit PC of each subpixel SP via the power lines PL1. In the example of FIG. 9, the power lines PL1 extending in the Y-direction are provided in the display area DA.

An end of each power line PL1 is connected to a connection portion CN1, and the other end is connected to a connection portion CN2. Both the connection portion CN1 and the connection portion CN2 are located in the surrounding area SA. In the example of FIG. 9, the connection portions CN1 and CN2 have shapes which are curved along the display area DA.

The connection portion CN1 is located between the display area DA and the terminal portion T and is connected to the terminal portion T by a pair of lines L1 and L2. Power source voltage VDDEL is applied to each power line PL1 via the terminal portion T, the lines L1 and L2 and the connection portion CN1.

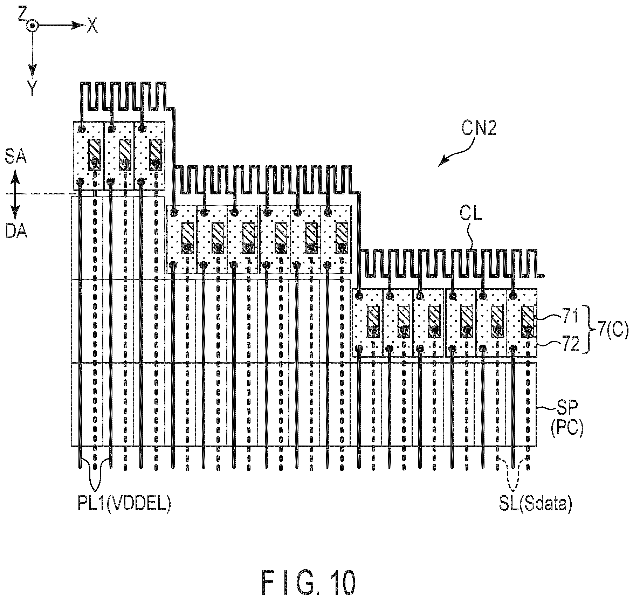

FIG. 10 is a plan view showing a schematic configuration of the connection portion CN2. In this figure, as the elements provided in the display area DA, the pixel circuits PC, the power lines PL1 and the signal lines SL are shown.

As shown in FIG. 1 and FIG. 9, the display area DA is oval as a whole. This shape is realized by providing the pixel circuits PC (subpixels SP) in a staircase pattern in the edge portion of the display area DA as shown in FIG. 10.

The pixel circuits PC (subpixels SP) to which power source voltage VDDEL is applied by one power line PL1 are arranged in the Y-direction. From another viewpoint, the pixel circuits PC (subpixels SP) to which video signals Sdata are applied by one signal line SL are arranged in the Y-direction.

The connection portion CN2 comprises a plurality of correction capacitive portions 7. In the example of FIG. 10, each capacitive portion 7 is provided for a corresponding pair consisting of a power line PL1 and a signal line SL. It should be noted that a signal line SL for which no correction capacitive portion 7 is provided may be present.

Each correction capacitive portion 7 comprises at least one capacitive electrode (first capacitive electrode) 71 and at least one capacitive electrode (second capacitive electrode) 72. The capacitive electrode 71 is connected to the signal line SL. The capacitive electrode 72 is connected to the power line PL1. The voltage of the signal line SL is applied to the capacitive electrode 71. Power source voltage VDDEL of the power line PL1 is applied to the capacitive electrode 72.

The capacitive electrodes 71 and 72 face each other in the Z-direction. By this structure, correction capacitance C which applies a load to the signal line SL is formed between the capacitive electrodes 71 and 72.

The capacitive electrodes 72 are connected by a connection line CL provided in the surrounding area SA. The connection line CL has a meandering shape. In other words, the connection line CL is bent a plurality of times between adjacent capacitive electrodes 72. From another viewpoint, the connection line CL has a wave shape in which a portion projecting to the upper side of the figure (in a direction moving away from the display area DA) and a portion projecting to the lower side of the figure (in a direction approaching the display area DA) are repeated a plurality of times. The connection line CL has a width which is sufficiently less than the capacitive electrodes 72.

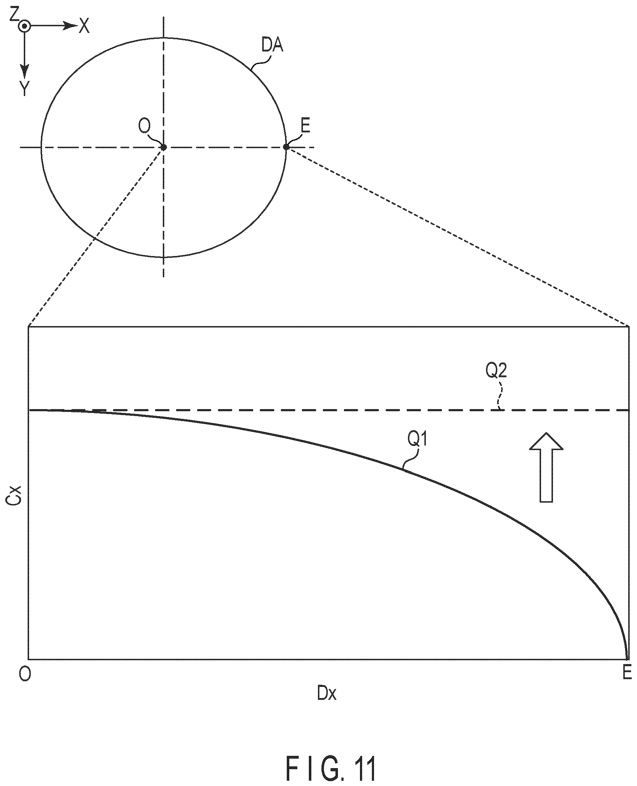

FIG. 11 is a diagram for explaining the function of the correction capacitance C. For example, when the display area DA is oval as in the case of this embodiment, the number of subpixels SP (pixel circuits PC) connected to each signal line SL may differ depending on the signal line SL.

Specifically, more pixel circuits PC are connected as the signal line SL is closer to the center O of the display area DA. This configuration differentiates the loads (capacitance) of the signal lines SL.

The graph of FIG. 11 shows an example of load Cx of the signal lines SL located between the center O of the display area DA and the end portion E in the X-direction. In this graph, the horizontal axis indicates distance Dx from center O. In the graph, the solid line indicates distribution Q1 of load Cx when the correction capacitive portion 7 is not present. In the graph, the broken line indicates distribution Q2 of load Cx when the correction capacitive portion 7 is present.

More pixel circuits PC are connected to each signal line SL located near center O. For this reason, as shown by distribution Q1, when the correction capacitive portion 7 is not present, load Cx of the signal line SL decreases with increasing distance from center O. This difference in load Cx may cause an undesired luminance distribution in the display area DA. Specifically, the luminance of each subpixel SP located near the end portion E having a less load Cx is high.

The correction capacitance C of the correction capacitive portion 7 eases this luminance distribution. In other words, the difference in loads Cx of the signal lines SL can be reduced by imparting greater correction capacitance C to each signal line SL closer to the end portion E. By this configuration, the luminance distribution of the display area DA is eased. For example, it is preferable that load Cx is uniform in the signal lines SL as in the case of distribution Q2.

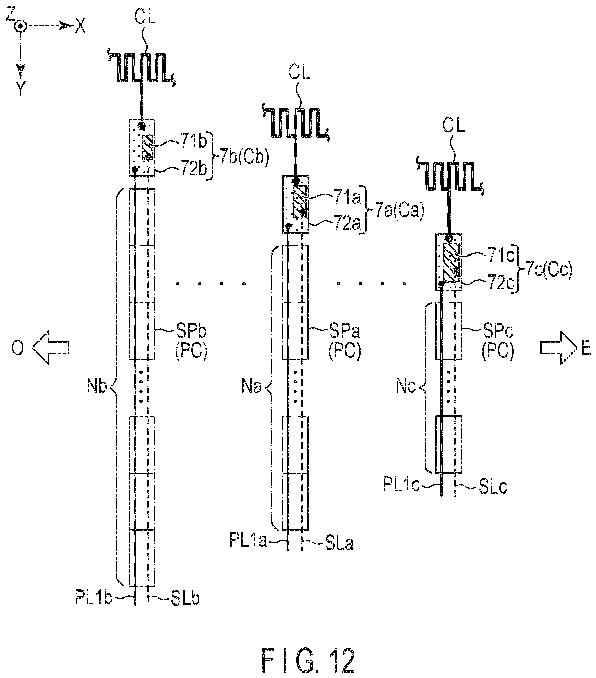

FIG. 12 is a diagram showing an example of the layout form of the correction capacitive portions 7. In this figure, three signal lines SL (SLa, SLb and SLc) are particularly looked at. The signal line SLa is connected to the pixel circuits PC of Na subpixels SPa. The signal line SLb is connected to the pixel circuits PC of Nb subpixels SPb. The signal line SLc is connected to the pixel circuits PC of Nc subpixels SPc.

Power source voltage VDDEL is applied to the pixel circuit PC of each subpixel SPa via a power line PL1a. Power source voltage VDDEL is applied to the pixel circuit PC of each subpixel SPb via a power line PL1b. Power source voltage VDDEL is applied to the pixel circuit PC of each subpixel SPc via a power line PL1c.

Correction capacitive portions 7a, 7b and 7c are connected to the signal lines SLa, SLb and SLc, respectively. Specifically, the signal line SLa is connected to the capacitive electrode 71a of the correction capacitive portion 7a. The power line PL1a is connected to the capacitive electrode 72a of the correction capacitive portion 7a. The signal line SLb is connected to the capacitive electrode 71b of the correction capacitive portion 7b. The power line PL1b is connected to the capacitive electrode 72b of the correction capacitive portion 7b. The signal line SLc is connected to the capacitive electrode 71c of the correction capacitive portion 7c. The power line PL1c is connected to the capacitive electrode 72c of the correction capacitive portion 7c.

The signal line SLb is located between the signal line SLa and the center O of the display area DA. Therefore, the number Nb of subpixels SPb is greater than the number Na of subpixels SPa (Nb > Na). To reduce this difference in the loads of the signal lines SLa and SLb caused by the difference in the numbers of subpixels SPa and SPb, the correction capacitance Ca of the correction capacitive portion 7a is set so as to be greater than the correction capacitance Cb of the correction capacitive portion 7b (Cb < Ca).

To the contrary, the signal line SLc is located between the signal line SLa and the end portion E of the display area DA in the X-direction. Therefore, the number Nc of subpixels SPc is less than the number Na of subpixels SPa (Nc < Na). To reduce this difference in the loads of the signal lines SLa and SLc caused by the difference in the numbers of subpixels SPa and SPc, the correction capacitance Cc of the correction capacitive portion 7c is set so as to be greater than the correction capacitance Ca of the correction capacitive portion 7a (Ca < Cc).

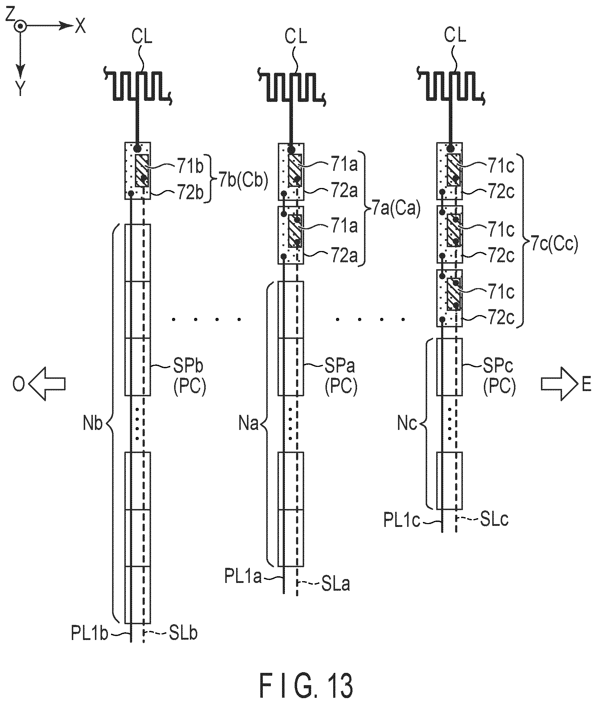

FIG. 13 is a diagram showing another example of the layout form of the correction capacitive portions 7. In the example of this figure, in a manner similar to that of the example of FIG. 12, the signal lines SLa, SLb and SLc are particularly looked at.

In the example of FIG. 13, the correction capacitive portion 7a has two capacitive electrodes 71a, and two capacitive electrodes 72a facing the capacitive electrodes 71a, respectively. The correction capacitive portion 7c has three capacitive electrodes 71c, and three capacitive electrodes 72c facing the capacitive electrodes 71c, respectively. The correction capacitive portion 7b has one capacitive electrode 71b and one capacitive electrode 72b in a manner similar to that of the example of FIG. 12.

In this manner, in the example of FIG. 13, more capacitive electrodes 71 are connected to each signal line SL in which the load by the pixel circuit PC is less, and capacitance is formed between these capacitive electrodes 71 and the capacitive electrodes 72. By this configuration, the correction capacitances Ca, Cb and Cc of the correction capacitive portions 7a, 7b and 7c can be adjusted, and the difference in the loads of the signal lines SLa, Slb and SLc can be reduced.

For example, the capacitance formed by one capacitive electrode 71a and one capacitive electrode 72a, the capacitance formed by one capacitive electrode 71b and one capacitive electrode 72b and the capacitance formed by one capacitive electrode 71c and one capacitive electrode 72c are the same as each other. As another example, these capacitances may be different from each other.

It should be noted that the number of electrodes 71 connected to one signal line SL is not limited to one, two or three. Unlike these examples of FIG. 13, more capacitive electrodes 71 may be connected.

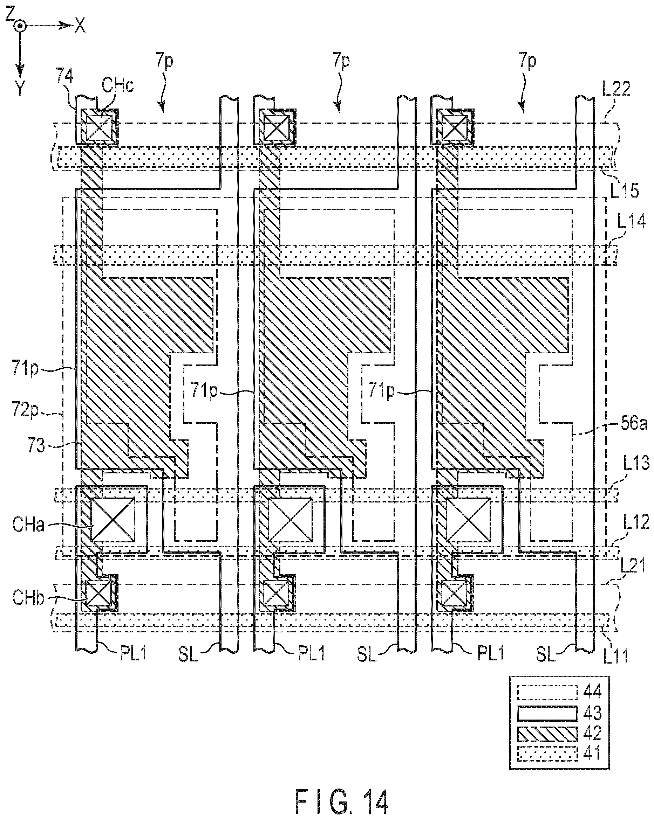

Now, this specification shows several specific practical examples which may be applied to the correction capacitive portions 7 with reference to FIG. 14 to FIG. 20. It should be noted that the configuration is not limited to these practical examples, and various configurations can be applied to the correction capacitive portions 7.

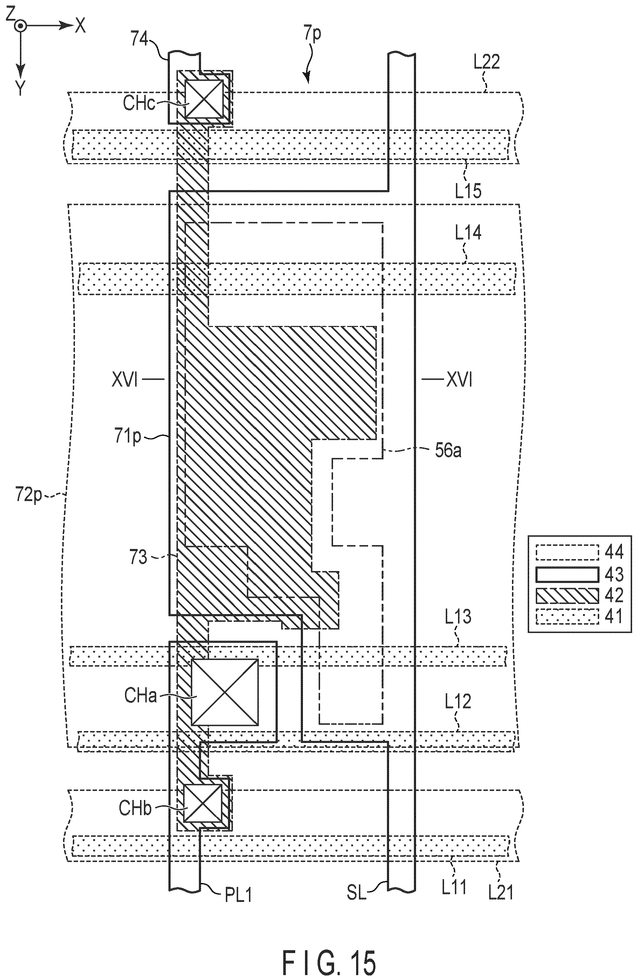

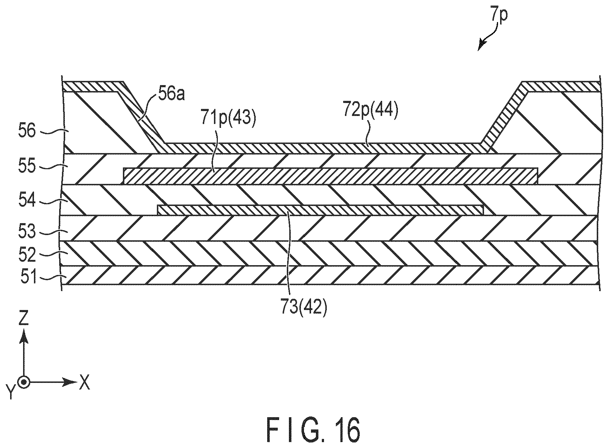

FIG. 14 is a schematic plan view of a plurality of correction capacitive portions 7 (correction capacitive portions 7p) according to a first practical example. FIG. 15 is a schematic plan view in which one correction capacitive portion 7p is enlarged. FIG. 16 is the schematic cross-sectional view of the correction capacitive portion 7p along the XVI-XVI line of FIG. 15.

The elements shown in FIG. 14 and FIG. 15 are mainly formed by the metal layers 41 to 44 shown in FIG. 6. FIG. 14 and FIG. 15 also show the correspondence relationship between the types of lines and hatching of the elements and the metal layers 41 to 44.

As shown in FIG. 14 and FIG. 15, each correction capacitive portion 7p has a capacitive electrode 71p, a capacitive electrode 72p and a capacitive electrode 73. The capacitive electrode 71p is formed by the metal layer 43. The capacitive electrode 72p is formed by the metal layer 44. The capacitive electrode 73 is formed by the metal layer 42. The signal line SL and the power line PL1 are formed by the metal layer 43. Thus, in the first practical example, the capacitive electrode (first capacitive electrode) 71p is formed of the same material as the signal line SL in the same layer as the signal line SL.

For example, the capacitive electrode 71p is integrally formed with the signal line SL. The capacitive electrode 72p is connected to the power line PL1 through a contact hole CHa which penetrates the inorganic insulating layer 55 and the organic insulating layer 56. The capacitive electrode 73 is connected to the power line PL1 through a contact hole CHb which penetrates the inorganic insulating layer 54.

In the example of FIG. 14, the capacitive electrode 72p has a size which overlaps three capacitive electrodes 71p. As another example, one capacitive electrode 72p may be provided for each capacitive electrode 71p.

In the example of FIG. 14 and FIG. 15, a portion of the capacitive electrode 73 extends to the upper side of the figure. This portion is connected to a relay line 74 formed by the metal layer 43 through a contact hole CHc which penetrates the inorganic insulating layer 54.

The connection line CL shown in FIG. 10 is connected to the relay line 74. The connection line CL can be formed by, for example, the metal layer 42. In this case, the relay line 74 and the connection line CL are connected to each other through a contact hole which penetrates the inorganic insulating layer 54. It should be noted that the configuration is not limited to this example, and the connection line CL may be formed by one of the metal layers 41, 43 and 44.

In the example of FIG. 14 and FIG. 15, lines L11 to L15 formed by the metal layer 41 and lines L21 and L22 formed by the metal layer 44 are provided. All of the lines L11 to L15, L21 and L22 extend in the X-direction. The lines L11 to L15, L21 and L22 are insulated from the signal line SL, the power line PL1, the capacitive electrodes 71p, 72p and 73 and the relay line 74.

For example, each of the scanning lines GL1 to GL4 shown in FIG. 2 is one of the lines L11 to L15. Each of the power lines PL2 and PL3 shown in FIG. 2 is one of the lines L21 and L22. In other words, in the first practical example, the capacitive electrode (second capacitive electrode) 72p is formed of the same material as the power lines PL2 and PL3 in the same layer as the power lines PL2 and PL3.

As shown in FIG. 16, the organic insulating layer 56 has an aperture 56a. As shown in FIG. 14 and FIG. 15, the aperture 56a overlaps the capacitive electrodes 71p and 72p.

In the area where this aperture 56a is provided, the capacitive electrode 71p connected to the signal line SL faces the capacitive electrode 72p connected to the power line PL1 via the inorganic insulating layer 55 which is relatively thin. By this configuration, good capacitance is formed between the capacitive electrodes 71p and 72p. In addition, capacitance may be formed between the capacitive electrodes 71p and 73. These capacitances correspond to the correction capacitance C shown in FIG. 10 (in FIG. 12 and FIG. 13, the correction capacitances Ca, Cb and Cc).

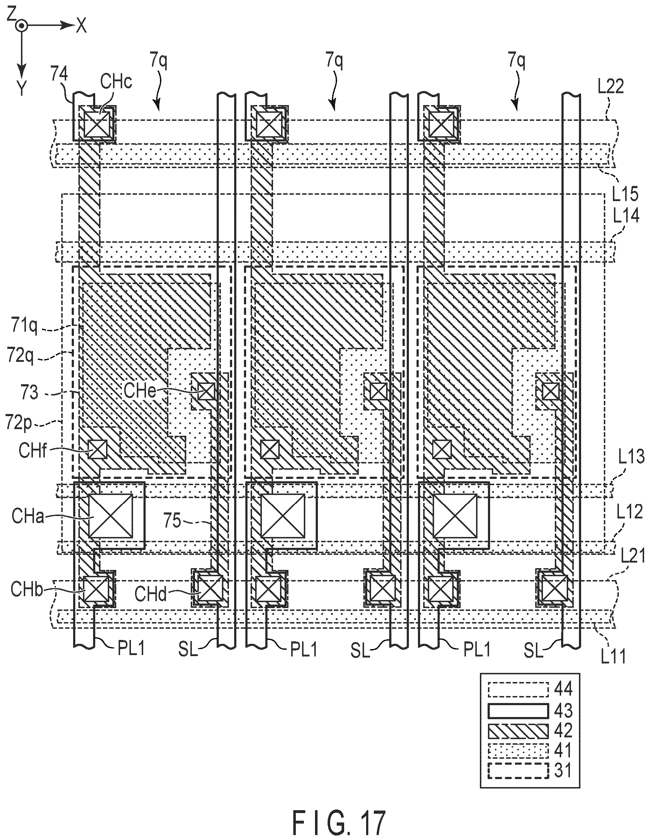

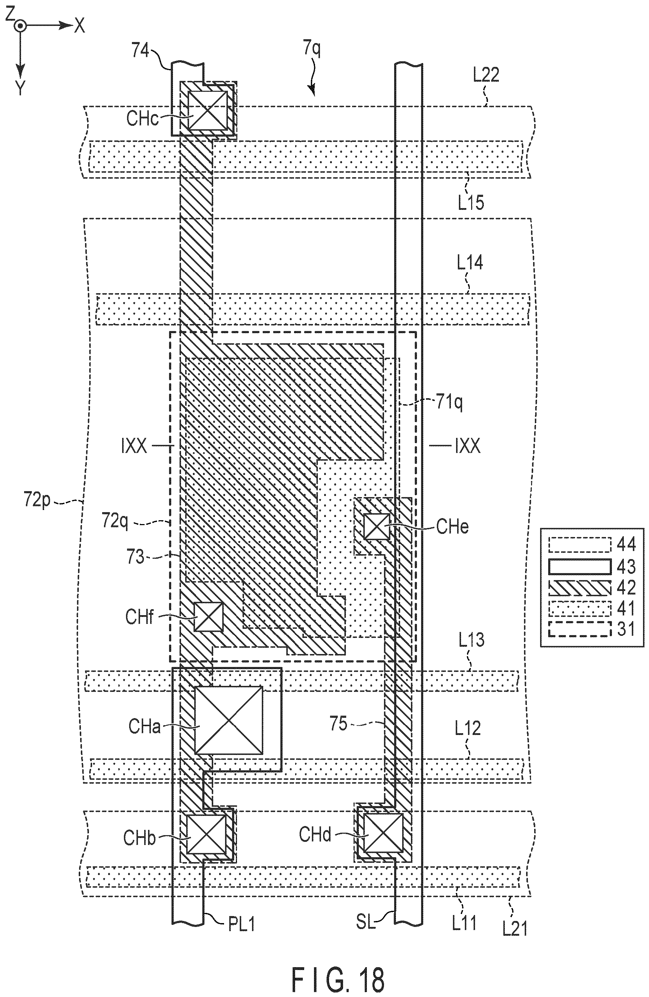

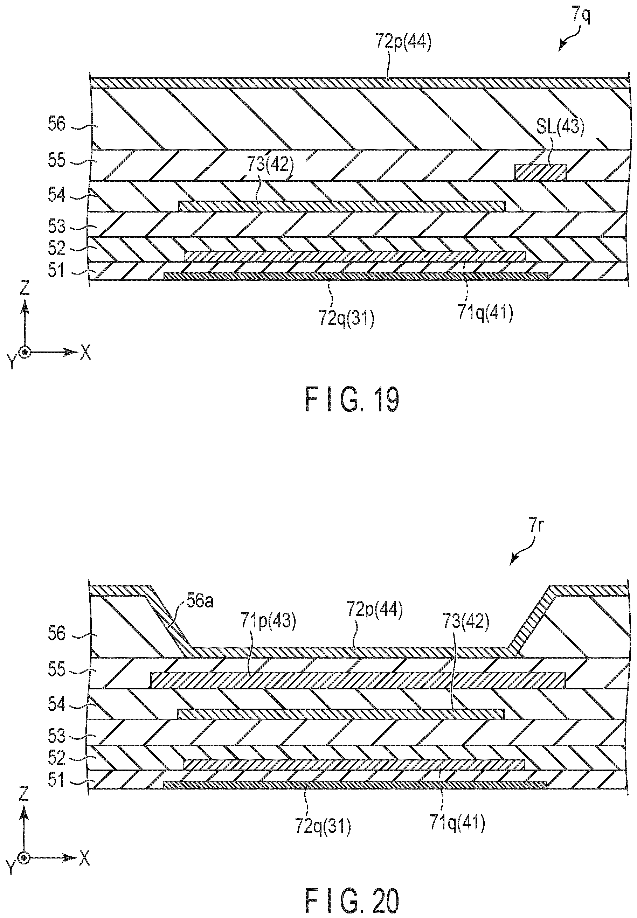

FIG. 17 is a schematic plan view of a plurality of correction capacitive portions 7 (correction capacitive portions 7q) according to a second practical example. FIG. 18 is a schematic plan view in which one correction capacitive portions 7q is enlarged. FIG. 19 is the schematic cross-sectional view of the correction capacitive portion 7q along the IXX-IXX line of FIG. 18.

The elements shown in FIG. 17 and FIG. 18 are mainly formed by the semiconductor layer 31 and metal layers 41 to 44 shown in FIG. 6. FIG. 17 and FIG. 18 also show the correspondence relationship between the types of lines and hatching of the elements and the semiconductor layer 31 and the metal layers 41 to 44.

As shown in FIG. 17 and FIG. 18, each correction capacitive portion 7q has a capacitive electrode 71q, a capacitive electrode 72q and a relay line 75. The correction capacitive portion 7q has capacitive electrodes 72p and 73 and a relay line 74 in a manner similar to that of each correction capacitive portion 7p of the first practical example. In the second practical example, the aperture 56a is not provided in the organic insulating layer 56.

The capacitive electrode 71q is formed by the metal layer 41. The capacitive electrode 72q is formed by the semiconductor layer 31. The relay line 75 is formed by the metal layer 42. In a manner similar to that of the first practical example, the capacitive electrode 73 is formed by the metal layer 42, and the signal line SL, the power line PL1 and the relay line 74 are formed by the metal layer 43.

Thus, each capacitive electrode (first capacitive electrode) 71q in the second practical example is formed in the same layer as the gate electrode GEa shown in FIG. 7 and the gate electrode GEb1 shown in FIG. 8, using the same material as these gate electrodes GEa and GEb1. The capacitive electrode (second capacitive electrode) 72q is formed in the same layer as the semiconductor SCa shown in FIG. 7, using the same material as the semiconductor SCa.

The relay line 75 is connected to the signal line SL through a contact hole CHd which penetrates the inorganic insulating layer 54. The capacitive electrode 71q is connected to the relay line 75 through a contact hole CHe which penetrates the inorganic insulating layers 52 and 53. In a manner similar to that of the first practical example, the capacitive electrode 72p is connected to the power line PL1 through a contact hole CHa which penetrates the inorganic insulating layer 55 and the organic insulating layer 56. The capacitive electrode 73 is connected to the power line PL1 through a contact hole CHb which penetrates the inorganic insulating layer 54. The capacitive electrode 72q is connected to the capacitive electrode 73 through a contact hole CHf which penetrates the inorganic insulating layers 51 to 53.

As shown in FIG. 17 and FIG. 18, the capacitive electrodes 71q, 72q and 73 overlap each other in plan view. As shown in FIG. 19, the capacitive electrodes 71q and 72q face each other via the inorganic insulating layer 51 which is relatively thin. By this configuration, good capacitance is formed between the capacitive electrode 71q connected to the signal line SL and the capacitive electrode 72q connected to the power line PL1. In addition, capacitance may be formed between the capacitive electrodes 71q and 73. These capacitances correspond to the correction capacitance C shown in FIG. 10 (in FIG. 12 and FIG. 13, the correction capacitances Ca, Cb and Cc).

FIG. 20 is a schematic cross-sectional view of a correction capacitive portion 7 (correction capacitive portion 7r) according to a third practical example. The correction capacitive portion 7r has a structure in which the correction capacitive portion 7p of the first practical example and the correction capacitive portion 7q of the second practical example are combined with each other.

Specifically, the correction capacitive portion 7r has a capacitive electrode (first capacitive electrode) 71p connected to the signal line SL, a capacitive electrode (second capacitive electrode) 72p connected to the power line PL1, a capacitive electrode (third capacitive electrode) 71q connected to the signal line SL, a capacitive electrode (fourth capacitive electrode) 72q connected to the power line PL1 and a capacitive electrode 73. In this configuration, correction capacitance C in which the correction capacitances of the correction capacitive portions 7p and 7q are combined can be obtained by the correction capacitive portion 7r.

The planar shapes of the capacitive electrodes 71p, 72p and 73 and the aperture 56a of the organic insulating layer 56 are the same as those shown in FIG. 15. The planar shapes of the capacitive electrodes 71q and 72q are the same as those shown in FIG. 18.

For example, the correction capacitance C of the correction capacitive portion 7p is greater than the correction capacitance C of the correction capacitive portion 7q. In this case, the correction capacitive portion 7p may be applied to the correction capacitive portion 7a shown in FIG. 12, and the correction capacitive portion 7q may be applied to the correction capacitive portion 7b, and the correction capacitive portion 7r may be applied to the correction capacitive portion 7c.

According to the embodiment described above, as explained using FIG. 11, the provision of the correction capacitive portions 7 can reduce the difference in the loads Cx of the signal lines SL and ease an undesired luminance distribution in the display area DA.

In an electronic device on which the display device DSP is mounted, in some cases, an antenna for near field communication (NFC) may be provided in the back of the display device DSP. In this case, if the both end portions of each power line PL1 are connected by the connection portions CN1 and CN2 as shown in FIG. 9, a conductor consisting of each power line PL1 and the connection portions CN1 and CN2 becomes a cause to reduce the sensitivity of wireless communication performed by the antenna described above.

Specifically, eddy current is generated in the conductor described above by a magnetic field formed by the antenna described above. By this eddy current, a magnetic field having a direction which negates the above magnetic field is formed, and the signal strength is attenuated. Thus, when wireless communication is performed via the display device DSP, the communication sensitivity could be decreased. In particular, when the capacitive electrode 72 of each correction capacitive portion 7 is formed of a metal material whose width is great, the resistance of the connection portion CN2 is low. Thus, a large eddy current and a strong magnetic field associated with the eddy current are generated in the conductor, and the communication sensitivity easily decreases.

To the contrary, in the embodiment, the capacitive electrodes 72 are connected by the meandering connection line CL as shown in FIG. 10. In this case, the resistance of the connection portion CN2 can be made high compared to a case where the capacitive electrodes 72 are integrally connected to each other or are connected by a linear line. As a result, the generation of the above eddy current can be prevented, thereby increasing the communication sensitivity of near field communication.

In the embodiment, the configuration related to the correction capacitive portions 7 is explained using the example of the display device DSP in which the display area DA is oval. When the display area DA has this shape, the loads of the signal lines SL are not uniform as explained with reference to FIG. 9. Therefore, the loads need to be adjusted by the correction capacitive portions 7.

The loads of the signal lines SL may be nonuniform in a display area DA having the shape of a precise circle as well as the oval display area DA. In addition, for example, in a case where the display area DA is substantially rectangular, and a notch for providing a camera is provided in one of the sides of the display area DA, the loads of the signal lines SL may become nonuniform. The configuration related to the correction capacitive portions 7 disclosed in this embodiment brings about a satisfactory effect even when the configuration is applied to a display device DSP having a display area DA with a shape other than an oval as described above.

All of the display devices that can be implemented by a person of ordinary skill in the art through arbitrary design changes to the display device disclosed as each embodiment described above come within the scope of the present invention as long as they are in keeping with the spirit of the present invention.

Various modification examples which may be conceived by a person of ordinary skill in the art in the scope of the idea of the present invention will also fall within the scope of the invention. For example, even if a person of ordinary skill in the art arbitrarily modifies the above embodiments by adding or deleting a structural element or changing the design of a structural element, or by adding or omitting a step or changing the condition of a step, all of the modifications fall within the scope of the present invention as long as they are in keeping with the spirit of the invention.

Further, other effects which may be obtained from the above embodiments and are self-explanatory from the descriptions of the specification or can be arbitrarily conceived by a person of ordinary skill in the art are considered as the effects of the present invention as a matter of course.

## Claims

1. A display device (DSP) **characterized by** comprising:
a plurality of first subpixels (SPa) arranged in a display area (DA);
a plurality of second subpixels (SPb) arranged in the display area (DA);
a first signal line (SLa) which supplies a video signal to each of the first subpixels (SPa);
a second signal line (SLb) which supplies a video signal to each of the second subpixels (SPb);
a first correction capacitive portion (7a) which is provided in a surrounding area (SA) located around the display area (DA) and is connected to the first signal line (SLa);
a second correction capacitive portion (7b) provided in the surrounding area (SA) and connected to the second signal line (SLb); and
a connection line (CL) which connects the first correction capacitive portion (7a) and the second correction capacitive portion (7b) to each other and has a meandering shape.

2. The display device (DSP) of claim 1, wherein each of the first correction capacitive portion (7a) and the second correction capacitive portion (7b) includes a first capacitive electrode (71) and a second capacitive electrode (72) which forms correction capacitance between the first capacitive electrode (71) and the second capacitive electrode (72),
the first capacitive electrode (71a) of the first correction capacitive portion (7a) is connected to the first signal line (SLa),
the first capacitive electrode (71b) of the second correction capacitive portion (7b) is connected to the second signal line (SLb), and
the second capacitive electrode (72a) of the first correction capacitive portion (7a) and the second capacitive electrode (72b) of the second correction capacitive portion (7b) are connected to the connection line (CL).

3. The display device (DSP) of claim 2, wherein
the first subpixels (SPa) are different from the second subpixels (SPb) in number, and
the correction capacitance of the first correction capacitive portion (7a) is different from the correction capacitance of the second correction capacitive portion (7b).

4. The display device (DSP) of claim 3, wherein
the number of first subpixels (SPa) is greater than the number of second subpixels (SPb), and
the correction capacitance of the first correction capacitive portion (7a) is less than the correction capacitance of the second correction capacitive portion (7b) .

5. The display device (DSP) of claim 2, wherein
the first capacitive electrode (71a, 71b) of at least one of the first correction capacitive portion (7a) and the second correction capacitive portion (7b) is formed of a same material as the first signal line (SLa) and the second signal line (SLb) in a same layer as the first signal line (SLa) and the second signal line (SLb).

6. The display device (DSP) of claim 5, further comprising a power line (PL1a, PL1b) which applies power source voltage to each of the first subpixels (SPa) and the second subpixels (SPb), wherein
each of the first subpixels (SPa) and the second subpixels (SPb) includes:
a pixel circuit (PC) connected to the power line (PL1a, PL1b);
a lower electrode (LE1, LE2, LE3) connected to the pixel circuit (PC);
an upper electrode (UE1, UE2, UE3) which faces the lower electrode (LE1, LE2, LE3); and
an organic layer (OR1, OR2, OR3) which is located between the lower electrode (LE1, LE2, LE3) and the upper electrode (UE1, UE2, UE3) and emits light based on application of voltage, and
the second capacitive electrode (72a, 72b) of at least one of the first correction capacitive portion (7a) and the second correction capacitive portion (7b) is formed of a same material as the power line (PL1a, PL1b) in a same later as the power line (PL1a, PL1b).

7. The display device (DSP) of claim 2, wherein
each of the first subpixels (SPa) and the second subpixels (SPb) includes:
a pixel circuit (PC) comprising a transistor (TRa, TRb) including a gate electrode (GEa) and a semiconductor (SCa);
a lower electrode (LE1, LE2, LE3) connected to the pixel circuit (PC);
an upper electrode (UE1, UE2, UE3) which faces the lower electrode (LE1, LE2, LE3); and
an organic layer (OR1, OR2, OR3) which is located between the lower electrode (LE1, LE2, LE3) and the upper electrode (UE1, UE2, UE3) and emits light based on application of voltage, and
the first capacitive electrode (71a, 71b) of at least one of the first correction capacitive portion (7a) and the second correction capacitive portion (7b) is formed of a same material as the gate electrode (GEa) in a same layer as the gate electrode (GEa).

8. The display device (DSP) of claim 7, wherein
the second capacitive electrode (72a, 72b) of at least one of the first correction capacitive portion (7a) and the second correction capacitive portion (7b) is formed of a same material as the semiconductor (SCa) in a same layer as the semiconductor (SCa).

9. The display device (DSP) of any one of claims 1 to 4, wherein
each of the first subpixels (SPa) and the second subpixels (SPb) includes:
a lower electrode (LE1, LE2, LE3);
an upper electrode (UE1, UE2, UE3) which faces the lower electrode (LE1, LE2, LE3); and
an organic layer (OR1, OR2, OR3) which is located between the lower electrode (LE1, LE2, LE3) and the upper electrode (UE1, UE2, UE3) and emits light based on application of voltage.

10. The display device (DSP) of claim 9, further comprising a partition (6) which surrounds each of the first subpixels (SPa) and the second subpixels (SPb), wherein
the partition (6) includes a conductive lower portion (61) and an upper portion (62) which protrudes from a side surface of the lower portion (61).

11. The display device (DSP) of claim 10, wherein
the upper electrode (UE1, UE2, UE3) is in contact with the side surface of the lower portion (61).

12. A display device (DSP) **characterized by** comprising:
a plurality of subpixels (SP) provided in a display area (DA);
a signal line (SL) which supplies a video signal to each of the subpixels (SP);
a power line (PL1) which applies power source voltage to each of the subpixels (SP); and
a correction capacitive portion (7) which is provided in a surrounding area (SA) located around the display area (DA) and is connected to the signal line (SL), wherein
each of the subpixels (SP) includes:
a pixel circuit (PC) connected to the signal line (SL) and the power line (PL1);
a lower electrode (LE1, LE2, LE3) connected to the pixel circuit (PC);
an upper electrode (UE1, UE2, UE3) which faces the lower electrode (LE1, LE2, LE3); and
an organic layer (OR1, OR2, OR3) which is located between the lower electrode (LE1, LE2, LE3) and the upper electrode (UE1, UE2, UE3) and emits light based on application of voltage, and
the correction capacitive portion (7) includes:
a first capacitive electrode (71) formed of a same material as the signal line (SL) in a same layer as the signal line (SL) and connected to the signal line (SL); and
a second capacitive electrode (72) formed of a same material as the power line (PL1) in a same layer as the power line (PL1) and forming correction capacitance between the first capacitive electrode (71) and the second capacitive electrode (72).

13. The display device (DSP) of claim 12, wherein the correction capacitive portion (7) further includes:
a third capacitive electrode (71q) connected to the signal line (SL); and
a fourth capacitive electrode (72q) which forms correction capacitance between the third capacitive electrode (71q) and the fourth capacitive electrode (72q).

14. The display device (DSP) of claim 13, wherein
the pixel circuit (PC) comprises a transistor (TRa) including a gate electrode (GEa) and a semiconductor (SCa), and
the third capacitive electrode (71q) is formed of a same material as the gate electrode (GEa) in a same later as the gate electrode (GEa).

15. The display device (DSP) of claim 14, wherein
the fourth capacitive electrode (72q) is formed of a same material as the semiconductor (SCa) in a same later as the semiconductor (SCa).

16. The display device (DSP) of claim 13, further comprising a partition (6) which surrounds each of the subpixels (SP), wherein
the partition (6) includes a conductive lower portion (61) and an upper portion (62) which protrudes from a side surface of the lower portion (61).

17. The display device (DSP) of claim 16, wherein
the upper electrode (UE1, UE2, UE3) is in contact with the side surface of the lower portion (61).

18. A display device (DSP) **characterized by** comprising:
a plurality of subpixels (SP) provided in a display area (DA);
a signal line (SL) which supplies a video signal to each of the subpixels (SP); and
a correction capacitive portion (7) which is provided in a surrounding area (SA) located around the display area (DA) and is connected to the signal line (SL), wherein
each of the subpixels (SP) includes:
a pixel circuit (PC) which comprises a transistor (TRa) including a gate electrode (GEa) and a semiconductor (SCa) and is connected to the signal line (SL) ;
a lower electrode (LE1, LE2, LE3) connected to the pixel circuit (PC);
an upper electrode (UE1, UE2, UE3) which faces the lower electrode (LE1, LE2, LE3); and
an organic layer (OR1, OR2, OE3) which is located between the lower electrode (LE1, LE2, LE3) and the upper electrode (UE1, UE2, UE3) and emits light based on application of voltage, and
the correction capacitive portion (7) includes:
a first capacitive electrode (71) formed of a same material as the gate electrode (GEa) in a same layer as the gate electrode (GEa) and connected to the signal line (SL); and
a second capacitive electrode (72) formed of a same material as the semiconductor in a same layer as the semiconductor (SCa) and forming correction capacitance between the first capacitive electrode (71) and the second capacitive electrode (72).

19. The display device (DSP) of claim 18, further comprising a partition (6) which surrounds each of the subpixels (SP), wherein
the partition (6) includes a conductive lower portion (61) and an upper portion (62) which protrudes from a side surface of the lower portion (61).

20. The display device (DSP) of claim 19, wherein
the upper electrode (UE1, UE2, UE3) is in contact with the side surface of the lower portion (61).
